# EUROPEAN PATENT APPLICATION

(11) **EP 4 671 778 A1**
(43) Date of publication of application: **31.12.2025**
(21) Application number: 25178422.9
(22) Date of filing: 23.05.2025
(51) Int. Cl.: G01R 31/28

(54) **TWO-PHASE COOLING WITH ASSISTED CONDENSATION FOR SEMICONDUCTOR DEVICES**

(30) Priority: 28.06.2024 US 202418759292
(71) Applicant: INTEL Corporation, Santa Clara, CA 95054 (US)
(72) Inventor: ALELYANI, Sami, Phoenix, 85042 (US); PETRINI, Joseph B., Gilbert, 85297 (US); LOFGREEN, Kelly P., Phoenix, 85048 (US); DIGLIO, Paul J., Hillsboro, 97124 (US)
(74) Representative: HGF

(57) **Abstract**

Systems for heat management of semiconductor systems are provided. The heat management systems can provide liquid cooling or heating for a plurality of semiconductor devices under test. The systems are also useful for liquid cooling of computing systems, such as datacenters.

## Description

### FIELD

Descriptions are generally related to thermal management of semiconductor devices and more particularly to fluid-based multi-phase heating and cooling systems with assisted condensation for thermal management of semiconductor devices.

### BACKGROUND

Semiconductor chips are central to intelligent devices and systems, such as personal computers, laptops, tablets, phones, servers, and other consumer and industrial products and systems. Manufacturing semiconductor chips presents a number of challenges and these challenges are amplified as devices become smaller and performance demands increase. Challenges include, for example, unwanted material interactions, precision and scaling requirements, power delivery requirements, limited failure tolerance, and material and manufacturing costs.

The operation of a semiconductor device can create heat which can be dissipated, for example, through air cooling or liquid cooling. High temperatures can negatively impact the performance of a semiconductor device. Semiconductor chip testing is currently an essential part of the manufacturing process. After fabrication, a semiconductor device is tested to ensure it operates as expected and within certain parameters. Burn-in testing, for example, exposes a semiconductor device to conditions that can cause failure before the device is assembled into an end-user system. One method of testing a semiconductor device (a device under test or DUT), involves analyzing DUT operation over a carefully controlled temperature range. Devices that fail to operate as expected, for example, over the temperature range associated with an end-user's device operation, are typically discarded.

### BRIEF DESCRIPTION OF THE DRAWINGS

The figures are provided to aid in understanding the disclosure. The figures can include diagrams and illustrations of examples of structures, assemblies, data, methods, and systems. For ease of explanation and understanding, these structures, assemblies, data, methods, and systems, the figures are not an exhaustively detailed description. The figures therefore should not be understood to depict the entire metes and bounds of structures, assemblies, data, methods, and systems possible without departing from the scope of the disclosure. Additionally, features are not necessarily illustrated relatively to scale due in part to the small sizes of some features and the desire for clarity of explanation in the figures.
**Figure 1** provides a thermal test chamber assembly and a semiconductor device to be tested in the thermal test chamber assembly.
**Figures 2A - 2B** illustrate cooling systems that employ a fluid and that are useful for thermal management of one or more semiconductor devices.
**Figure 3** shows a cooling system that employs a fluid and that is useful for thermal management of semiconductor devices.
**Figure 4** provides a method for thermal system management of a semiconductor device testing system.
**Figure 5** provides a method for management of a liquid cooling system for a semiconductor device system.
**Figure 6** illustrates an example of a computing system.

Descriptions of certain details and implementations follow, including non-limiting descriptions of the figures, which depict some examples and implementations.

### DETAILED DESCRIPTION

References to one or more examples are to be understood as describing a particular feature, structure, or characteristic included in at least one implementation. The phrases "one example" or "an example" are not necessarily all referring to the same example or embodiment. Any aspect described herein can potentially be combined with any other aspect or similar aspect described herein, regardless of whether the aspects are described with respect to the same figure or element.

The words "connected" and/or "coupled" can indicate that two or more elements are in direct physical or electrical contact with each other. The term "coupled," however, can also mean that two or more elements are not in direct contact with each other and are instead separated by one or more elements but they may still co-operate or interact with each other, for example, physically, magnetically, optically, or electrically.

The words "first," "second," and the like, do not indicate order, quantity, or importance, but rather are used to distinguish one element from another. The words "a" and "an" herein do not indicate a limitation of quantity, but rather denote the presence of at least one of the referenced items. The terms "follow" or "after" can indicate immediately following or following some other event or events. Other sequences of operations can also be performed according to alternative embodiments. Furthermore, additional operations may be added or removed depending on the application.

Disjunctive language such as the phrase "at least one of X, Y, or Z," is used in general to indicate that an element or feature, may be either X, Y, or Z, or any combination thereof (e.g., X, Y, and/or Z). Thus, this disjunctive language should be understood not to imply that certain embodiments require at least one of X, at least one of Y, or at least one of Z to each be present.

Flow diagrams as illustrated herein provide examples of sequences of various process actions. The flow diagrams can indicate operations to be executed by a software or firmware routine, as well as physical operations. Physical operations can also be performed by semiconductor processing and/or testing equipment, including computer systems that run testing protocols and operate aspects of testing equipment and systems. Although shown in a particular sequence or order, unless otherwise specified, the order of the actions can be modified. Thus, the illustrated diagrams should be understood only as examples, and a process can be performed in a different order, and some actions can be performed in parallel. Additionally, one or more actions can be omitted and not all implementations may necessarily perform all actions.

Various components described can be a means for performing the operations or functions described. Components described can include software, hardware, or a combination of these. Some components can be implemented as software modules, hardware modules, special-purpose hardware (for example, application specific hardware, application specific integrated circuits (ASICs), and digital signal processors (DSPs)), embedded controllers, and/or hardwired circuitry.

To the extent various computer operations or functions are described herein, they can be described or defined as software code, instructions, configuration, and/or data. The software content can be provided via an article of manufacture with the content stored thereon, or via a method of operating a communication interface to send data via the communication interface. A machine-readable storage medium can cause a machine to perform the functions or operations described. A machine-readable storage medium includes any mechanism that stores information in a tangible form accessible by a machine (e.g., computing device), such as recordable/non-recordable media (e.g., read only memory (ROM), random access memory (RAM), magnetic disk storage media, optical storage media, flash memory devices). Instructions can be stored on the machine-readable storage medium in a non-transitory form. A communication interface includes any mechanism that interfaces to, for example, a hardwired, wireless, or optical medium to communicate to another device, such as, for example, a memory bus interface, a processor bus interface, an Internet connection, a disk controller.

Terms such as chip, die, IC (integrated circuit) chip, IC die, microelectronic chip, microelectronic die, semiconductor die, semiconductor device, and/or semiconductor chip are interchangeable and refer to a device comprising integrated circuits that can be formed, in part from semiconductor materials.

Semiconductor chip manufacturing processes are sometimes divided into front end of the line (FEOL) processes and back end of the line (BEOL) processes. Electronic circuits and active and passive devices within the chip, such as for example, transistors, capacitors, resistors, and/or memory cells, are manufactured in what can be referred to as FEOL processes. Memory cells include, for example, electronic circuits for random access memory (RAM), such as static RAM (sRAM), dynamic RAM (DRAM), read only memory (ROM), non-volatile memory, and/or flash memory. FEOL processes can be, for example, complementary metal-oxide semiconductor (CMOS) processes. BEOL processes include metallization of the chip where interconnects are formed in layers and the feature size of the interconnect increases in layers nearer the surface of the semiconductor chip. Interconnects in, for example, semiconductor chips that are integrated into heterogeneous packages (such as, for example, packages that include memory and logic chips), can also include through silicon vias (TSVs) that transverse the semiconductor chip device region. Semiconductor devices that have TSVs can blur distinctions between BEOL and FEOL processes.

The terms "package," "packaging," "IC package," or "chip package," "microelectronics package," or "semiconductor chip package" are interchangeable and generally refer to an enclosed carrier of one or more dies, in which the dies are attached to a package substrate and encapsulated. The package substrate provides electrical interconnects between the die(s) and other dies and/or a motherboard or other circuit board for I/O (input/output) communication and power delivery. A package with multiple dies can, for example, be a system in a package.

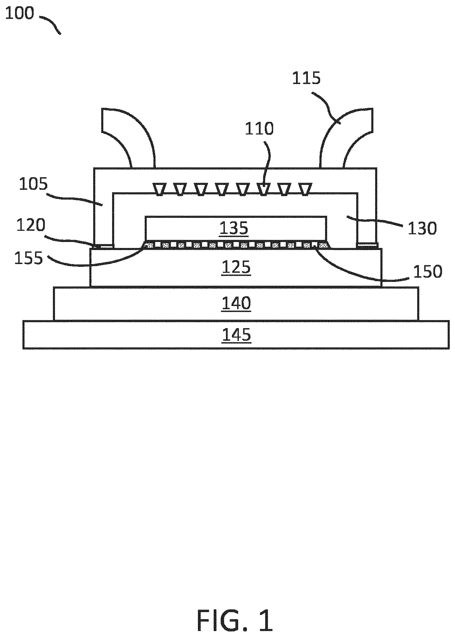

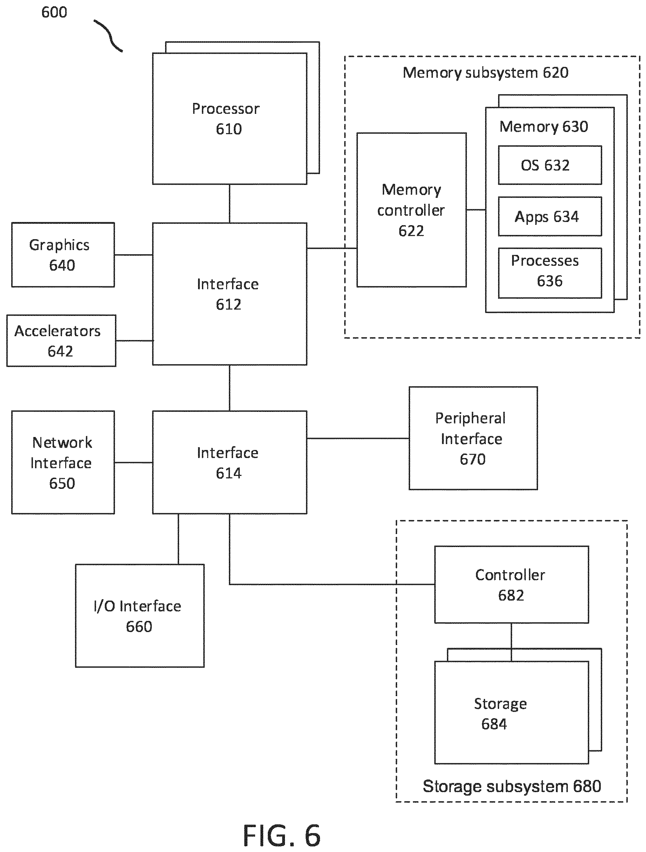

Figure 1 illustrates an example of a thermal test chamber assembly 100 that can be used as part of a system for testing the operation of semiconductor devices. The thermal test chamber assembly 100 can include a thermal head 105 that includes fluid delivery orifices 110 and fluid exit conduits 115. Although two fluid exit conduits 115 are shown in Figure 1, other numbers are possible, such as 1, 3, or more. Attachment of the thermal head 105 to the test substrate 125 or substrate carrier (not shown) creates isolated thermal chamber 130. Sealing join region 120 can be comprised of a sealant and/or an adhesive material that reversibly seals the thermal head 105 to the test substrate 125. The thermal test chamber assembly 100 can also include screws or clamps (not shown) that attach the thermal head 105 to the test substrate 125. Thermal chamber 130 is isolated from the atmosphere and can be pressurized and/or depressurized. The fluid delivery orifices 110 can be nozzles, apertures, orifices, or other devices for delivering a fluid to the thermal head chamber 130. The test substrate 125, much like a package substrate, can electrically couple a semiconductor device 135 to a test system (not shown) through a socket 140 and a circuit board 145. Test systems can comprise computing systems that run testing protocols and operate aspects of testing equipment and systems. Semiconductor device 135 can be reversibly attached to the test substrate 125 through first level interconnects 150. An insulating material 155 surrounds first level interconnects 150. The insulating material 155 can be a flowable dielectric material such as an epoxy. The test system comprises software and/or logic for testing a semiconductor device and can comprise, for example, computing elements shown for computing system 600 in Figure 6. Other designs are possible for thermal chamber assemblies.

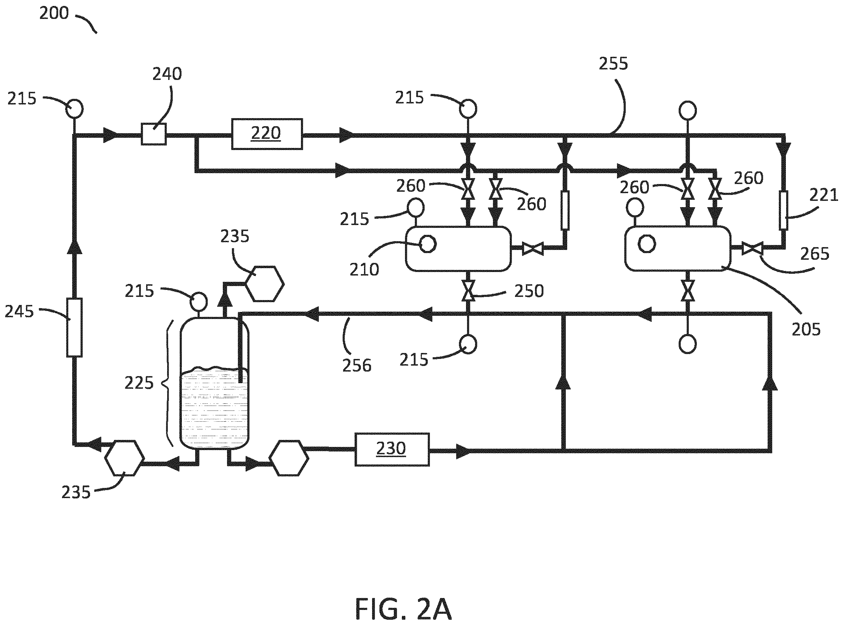

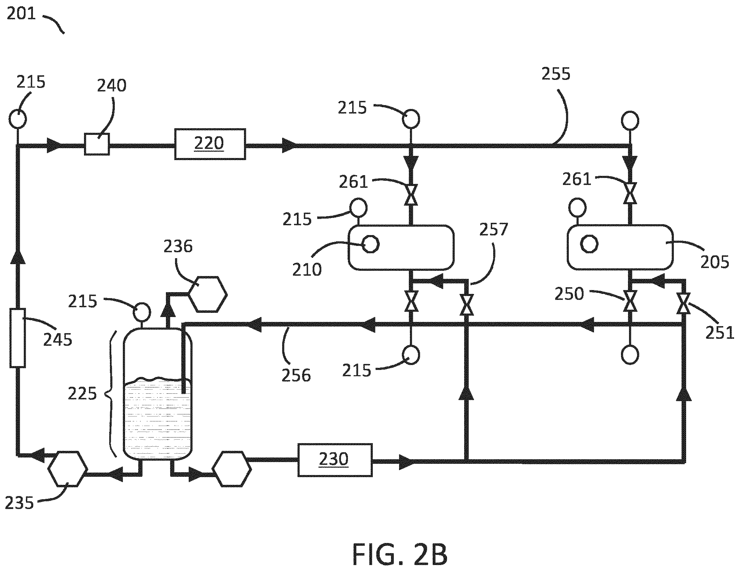

Figures 2A - 2B show thermal management systems 200 and 201 that can be used for heat management of one or more semiconductor devices. The thermal management systems 200 and 201 are capable of regulating the temperature of, for example, thermal test chambers 205 for semiconductor devices that are being tested (devices under test (DUTs)), such as, for example, the thermal test chamber assembly 100 of Figure 1. The thermal test chambers 205 include temperature sensors 210 and pressure sensors 215 that are capable of reporting out the temperature and pressure, respectively, to, for example, a computing system (not shown) that is testing a device under test. A computing system can include a temperature control function that operates to control the temperature of the device under test in response to a temperature measurement. The temperature sensors 210 can be, for example, resistance temperature detectors. Although two thermal test chambers 205 are shown in Figure 2, other numbers of thermal test chambers 205 are also possible, such as, for example, one thermal test chamber 205, three thermal test chambers 205, or more. It is possible to have, for example, 1 to 50 or more thermal test chambers 205. The thermal test chambers 205 can share a common in-line condensation system and can have independently controlled temperatures. In operation, thermal test chambers 205 can be run in parallel and the temperature of each thermal test chamber 205 can be set and regulated independently of the temperature of the other thermal test chambers 205.

Thermal management systems 200 and 201 can include heating units 220 and thermal management system 200 can also include heating units 221. The heating units 220 and 221 can be capable of heating a fluid to values in a temperature range that is needed for testing semiconductor devices. An example temperature range needed for testing semiconductor devices is 40 °C to 130 °C. The heating units 220 and/or 211 can heat a pressurized fluid to a temperature that is at or above the fluid's saturation temperature. Other temperature ranges are possible. The number of heating units 221 can vary, for example, between 0 and N, where N is the number of thermal test chambers 205 in a thermal management system 200 and N can be 50 or more. The number of thermal test chambers 205 is not limited by the amount of vapor.

Thermal management systems 200 and 201 also include a fluid reservoir 225 that can have a pressure sensor 215 and vacuum pump 235. In operation, the fluid reservoir 225 pressure can be independent of the saturation temperature and/or pressure of the one or more thermal test chambers 205. Additionally thermal management systems 200 and 201 can include a cooling unit 230 that is capable of cooling a fluid to a temperature that is less than the temperature of the fluid in the fluid reservoir 225. The temperature can be, for example, between 10 °C and 30 °C. Further, thermal management systems 200 and 201 can include a filter 245. The filter 245 can filter, for example, particles that are large enough that they could clog fluid delivery orifices 110, from a circulating fluid. The filter 245 can filter out, for example, particles having average dimensions (or diameters) of between 10 µm and 50 µm or between 0.1 µm and 1 µm. Thermal management systems 200 and 201 can also include an optional flow meter 240, and fluid conduits 255 and 256. Optionally, the flow meter 240 can communicate with a computing system (such as, for example, a computing system controlling the testing of the semiconductor devices) either wirelessly or through a wired connection, or a combination of wired and wireless communication pathways. Arrows indicate the direction of fluid flow in fluid conduits 255, 256, and 257. Sections of the fluid conduit system, i.e., fluid conduits 255, 256, and 257, are individually numbered for clarity of explanation, and can be the same or different types of fluid conduits.

Mixing valves 260 of thermal management system 200 are positioned to control the inflow of fluid at a first temperature and fluid at a second temperature (fluid from the heating unit 220 and fluid that has not passed through the heating unit 220) into thermal test chambers 205. Although mixing valves 260 are shown for thermal management system 200, they can also be used in thermal management system 201. Optional auxiliary inflow valves 265 are positioned to control the inflow of fluid from optional auxiliary heating units 221 (for thermal management system 200) into thermal test chambers 205 during system operation. Auxiliary inflow valves 265 and auxiliary heating units 221 can also be used in thermal management system 201. Mixing valves 260 are optional and, for example, thermal management system 201 optionally includes inflow control valves 261 instead that can control the inflow of fluid from the heating unit 220 into thermal test chambers 205 during system operation. Mixing valves 260, inflow control valves 261, and auxiliary valves 265 can be proportional valves or solenoid valves, for example. Outflow control valve 250 is positioned to control the outflow of fluid from the thermal test chambers 205. Outflow control valve 250 can be, for example, butterfly valves, proportional valves, or solenoid valves. Additionally, cooled fluid flow control valves 251 can be, for example, any type of valve, including on/off valves. Cooled fluid flow control valves 251 can control the fluid flow from the cooling unit 230.

Pressure sensors 215 located at various places in thermal management systems 200 and 201, can be the same or different types of sensors or gauges and some or all can have the ability to communicate with a computing system either wirelessly or through a wired connection. Locations for pressure sensors 215 include, for example, after the filter 245 and before the heating unit 220, associated with the thermal test chambers 205, so that a pressure inside the thermal test chambers 205 can be measured, and associated with the fluid reservoir 225, so that a pressure inside the fluid reservoir 225 can be measured. Pressure sensors 215 before and after the heating unit 220 can allow measurement of the inlet pressure before the fluid delivery orifices 110 exit (higher pressure). The pressure sensors 215 inside the thermal test chambers 205 are used to measure the thermal test chamber pressures (lower pressure).

Additionally, vacuum pumps 235 and 236 located at various places in thermal management systems 200 and 201, can be the same or different types of pumps and some or all can have the ability to communicate with a computing system (such as, for example, a computing system controlling the testing of the semiconductor devices) either wirelessly or through a wired connection, or a combination of wired and wireless communication pathways. Locations for vacuum pumps 235 and 236 include, for example, positioned in outflows from the fluid reservoir 225, and associated with the fluid reservoir 225 (236), so that a vacuum can be created in the fluid reservoir 225. It is also possible to use a centralized vacuum pump (for example, the manufacturing plant vacuum system), in which case the vacuum pump 236 can be replaced with a valve (for example, a proportional valve, a solenoid valve, or an on/off valve). Other locations and numbers of pressure sensors 215 and vacuum pumps 235 are possible.

In operation DUT temperature can be controlled, for example, by the modulation of the vapor content in the thermal test chambers 205. In some examples, a pressurized fluid at or above its saturation temperature is injected into thermal test chambers 205, and the fluid can become a multi-phase fluid in the thermal test chambers 205, so that the fluid is vapor and also liquid, or the fluid can become a vaporized fluid in the thermal test chambers 205. The injection and mixing of cooled fluid from fluid conduit section 256 (system 200) or fluid conduit section 257 (system 201), with the warmer fluid exiting the thermal test chambers 205, which can be in vapor form, can provide in-line condensation of vaporized fluid at the exit of the thermal test chambers 205. Because of the design of the system, the fluid conduit section 256 associated with the return conduit to the fluid reservoir 225 from the thermal test chambers 205 can have a relatively small diameter, for example, of 0.25 inches to 1.0 inches, 0.25 inches to 0.75 inches, or 0.375 inches to 0.5 inches. A fluid used in operation of the thermal management systems 200 and 201 can be, for example, water or a hydrofluoroether (HFE).

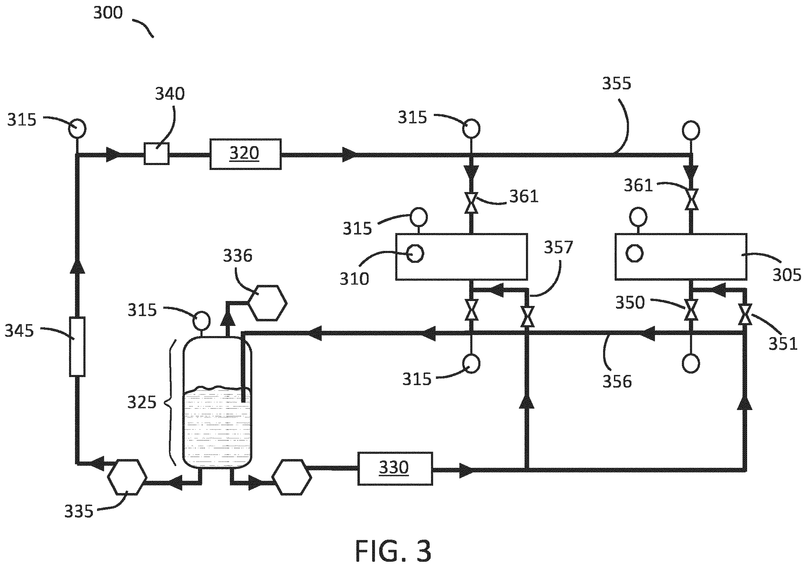

Figure 3 provides an additional example of a thermal management system implementation. The thermal management system 300 of Figure 3 is shown used for the thermal regulation of semiconductor device systems 305. The semiconductor device systems 305 can be, for example, all or parts of, computing systems, datacenters, telecom systems, supercomputers, servers, or any system comprising semiconductor devices, or any system where thermal management is an important consideration. Control of computing system temperatures to maintain a target temperature can, for example, maximize semiconductor device and system performance while minimizing the energy consumption of the cooling system. The semiconductor device systems 305 include fluid management systems that can be pipes or other devices that allow a fluid to absorb heat from the devices either directly or indirectly. Heat absorption may cause a liquid fluid to partially or fully vaporize within the cooling system. Although two semiconductor device systems 305 are shown in Figure 3, other numbers of semiconductor device systems 305 are possible, such as one system or three or more. It is possible to have, for example, 1 to 50 or more semiconductor device systems 305. For these semiconductor device systems 305, the temperature of each semiconductor device system 300 can be regulated independently of the temperatures of the other semiconductor device systems 305 that are part of the thermal management system 300. The semiconductor device systems 305 can include pressure sensors and/or temperature sensors 310 that optionally can communicate with a computing system that is managing the temperature of the computing system 305. The computing system can include a temperature control function that operates to control the temperature of the semiconductor system in response to a temperature measurement. The temperature sensors 310 can be, for example, resistance temperature detectors. Communication can occur through either a wired or wireless communication path, or a combination of wired and wireless communication pathways.

Thermal management system 300 includes a fluid reservoir 325 that can have a pressure sensor 315 and associated vacuum pump 335. In operation, the fluid reservoir 325 pressure can be independent of the saturation temperature and/or pressure of the one or more semiconductor device systems 305. Additionally thermal management system 300 can include a cooling unit 330 that is capable of cooling a fluid to a temperature of between, for example, between 40 °C and 130 °C, a filter 345, an optional flow meter 340, fluid conduits 355, 356, and 357. The filter 345 can, for example, filter out particles having average dimensions (or diameters) of between 10 µm and 50 µm. Sections of the fluid conduit system, i.e., fluid conduits 355, 356, and 357, are individually numbered for clarity of explanation and they can be the same or different types of fluid conduits. The heating unit 320 can be capable of heating a fluid to values in a temperature range that is needed for optimal performance of semiconductor devices. Optionally, the flow meter 340 and the heating unit 320 can communicate with a computing system capable of controlling temperature, either wirelessly or through a wired connection, or a combination of wired and wireless communication pathways. Arrows indicate the direction of fluid flow in fluid conduits 355, 356, and 357.

Thermal management system 300 can include inflow control valves 361 that can control the inflow of fluid from the heating unit 320 into semiconductor device systems 305 during system operation. Inflow control valves 361 can be proportional valves or solenoid valves, for example. Additionally, cold fluid flow control valves 351 can be, for example, any type of valve, including on/off valves. Cooled fluid flow control valves 351 can control the fluid flow from the cooling unit 330.

Although a fluid outflow system similar to that from the thermal test chambers 205 of Figure 2B is shown in Figure 3, in which cooled fluid is delivered via fluid conduit section 257 to outflow from thermal test chambers 205 before outflow valve 250, a fluid outflow system of Figure 2A is also possible in which the cooled fluid is injected into the outflow of semiconductor device systems 305 after outflow valve 350.

Outflow control valves 350 are positioned to control the outflow of fluid from the semiconductor device systems 305. Outflow valves 350 can be for example, butterfly valves, proportional valves, or solenoid valves. Fluid conduits 357 bring cooled fluid to the outflow of the semiconductor device systems 305 cooling systems. The injection and mixing of cooled fluid with the warmer fluid, which can be in vapor form, can provide in-line condensation at the exit of the semiconductor device systems 305 cooling systems.

Pressure sensors 315 located at various places in semiconductor device systems 305, can be the same or different types of sensors or gauges and some or all can have the ability to communicate with a computing system capable of controlling temperature, either wirelessly or through a wired connection, or a combination of wired and wireless communication pathways. Locations for pressure sensors 315 include, for example, after the filter 345 and before the flow meter 340, in the fluid containing regions of semiconductor device systems 305, and associated with the fluid reservoir 325 so that the pressure inside the fluid reservoir 325 can be measured. Additionally, vacuum pumps 335 and 336 in semiconductor device systems 305, can be the same or different types of pumps and some or all can have the ability to communicate with a computing system capable of controlling temperature, either wirelessly or through a wired connection, or a combination of wired and wireless communication pathways. Locations for vacuum pumps 335 include, for example, positioned in outflows from the fluid reservoir 325, and associated with the fluid reservoir 325 (336), so that a vacuum can be created in the fluid reservoir 325. It is also possible to use a centralized vacuum pump, in which case the vacuum pump 336 can be replaced with a valve (for example, a proportional valve, a solenoid valve, or an on/off valve). Other locations and numbers of pressure sensors 315 and vacuum pumps 335 are possible.

The temperature of each semiconductor device system 305 in thermal management system 300 can be controlled independently of other semiconductor device systems 305 in the thermal management system 300. Because of the design of the system, the fluid conduit section 356 associated with the return line to the fluid reservoir 325 from the semiconductor device systems 305 can have a relatively small diameter, for example, of 0.25 inches to 1.0 inches, 0.25 inches to 0.75 inches, or 0.375 inches to 0.5 inches. A fluid used in operation of the thermal management system 300 can be, for example, water or a hydrofluoroether (HFE).

In Figure 2A, hot fluid can be injected through auxiliary heating units 221 and auxiliary valves 265. By modulating auxiliary valves 265, the vapor content inside the thermal test chamber 205 can be modulated and the thermal test chamber 205 pressurized or depressurized. Stopping or lowering fluid flow depressurizes the thermal test chamber 205.

In Figures 2B and 3, each thermal test chamber 205 (or semiconductor device systems 305) pressure and temperature can be controlled independently with an outflow control valve 250 or 350 by running a lower temperature fluid at the exit of the thermal test chambers 205 (or semiconductor device systems 305). By modulating outflow control valve 250 or 350, a thermal test chamber 205 (or semiconductor device systems 305) can be pressurized or depressurized.

The inline condensation can allow vapor to be condensed as it flows out of the thermal test chambers 205 (or semiconductor device systems 305) so that the impact of the vapor's pressure on the system pressure and other thermal test chambers 205 (or semiconductor device systems 305) pressures is reduced or eliminated. In-line condensation of vapor exiting thermal test chambers 205 (or semiconductor device systems 305) can also allow control of each thermal test chamber 205 (or semiconductor device systems 305) pressure and temperature independently of each other with an outflow control valve 250 or 350.

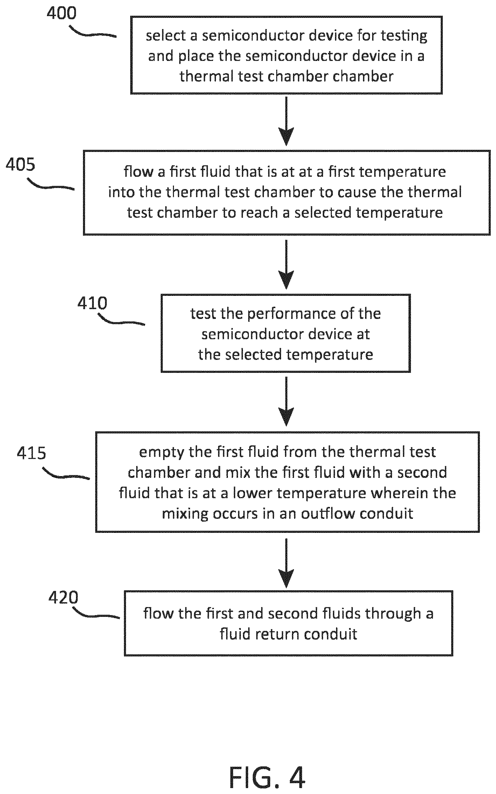

Figure 4 provides a method for managing a thermal system that regulates the temperature of a semiconductor device under test (DUT). The DUT can be housed in a thermal test chamber, such as, for example, the thermal test chamber assembly 100 shown in Figure 1 and described herein. Other types of thermal test chamber designs are also possible. Useful thermal regulation systems include the thermal management systems 200 and 201 of Figures 2A - 2B, and the accompanying descriptions herein, although other systems are also possible. In Figure 4, a semiconductor device is selected for testing and placed in a thermal test chamber 400. The temperature of the thermal test chamber is set to a selected temperature by, in part, flowing a first fluid that is at a first temperature into the thermal test chamber 405. The temperature of the thermal test chamber can also be modulated by changing the pressure inside the thermal test chamber. The performance of the semiconductor device is tested at the selected temperature 410. Testing the performance of a semiconductor device at a selected temperature can allow, for example, devices that fail prematurely at high temperature to be discarded. Testing can involve both heating and cooling a semiconductor device. The first fluid can be emptied from the thermal test chamber and the fluid outflow mixed with a second fluid that is at a lower temperature than the first fluid 415. The first fluid can comprise fluid in vapor form upon exiting the thermal test chamber, fluid that is in liquid form, or a mixture of vapor and liquid. In some examples, the first fluid can be at a temperature, for example that is between 90°C and 120 °C, and the second fluid can be at a temperature, for example, that is between 10 °C and 30 °C. The first and second fluid can be comprised of the same material. The first and second material can be comprised of, for example, water or a hydrofluoroether (HFE). The mixture of the first and second fluids can be flowed through a return conduit 420. In some examples, the return conduit from the thermal test chambers 205 can have a relatively small diameter, for example, of 0.25 inches to 1.0 inches, 0.25 inches to 0.75 inches, or 0.375 inches to 0.5 inches. The first and second fluids can be flowed through the return conduit to a fluid reservoir. The method of Figure 4 can be performed on a system that includes a plurality of thermal test chambers. In some examples, the plurality of thermal test chambers can be operated independently of each other so that a different temperature and/or pressure than that of a first thermal test chamber is possible for a second thermal test chamber.

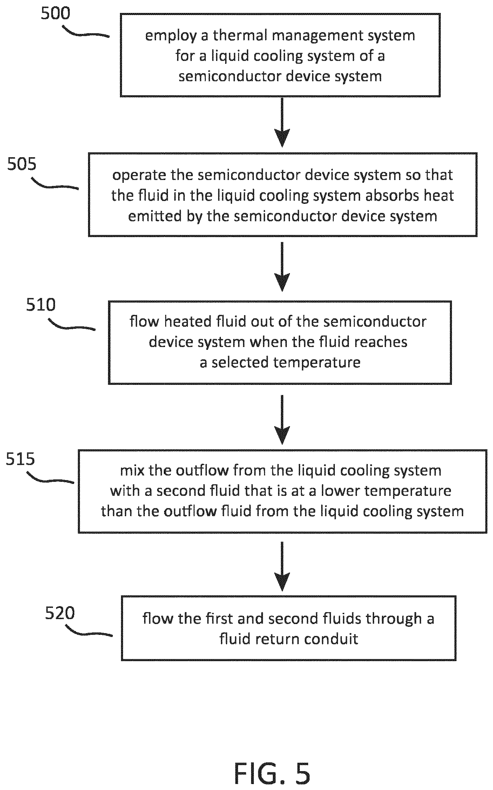

Figure 5 provides a method for managing a cooling system for a semiconductor device system. Managing a cooling system can be accomplished, for example, with a thermal management system 300 as shown in Figure 3 and described herein. The semiconductor device system can be, for example, all or parts of, computing systems, datacenters, telecom systems, supercomputers, servers, or any system comprising semiconductor devices, or any system where thermal management is an important consideration. In the method of Figure 5, the liquid cooling system for a semiconductor device system is managed by a thermal management system 500. In operation, the semiconductor device system generates heat which is absorbed by the liquid cooling system 505. When the semiconductor device system reaches a selected temperature, the first fluid is flowed out of the semiconductor device system and replaced with a third fluid that is at a lower temperature than the first fluid 510. The fluid outflow from the semiconductor device system is mixed with a second fluid that is at a lower temperature than the first fluid 515. The first and second fluids flow through a fluid return conduit 520. The first and second fluids can be flowed through the fluid return conduit to a fluid reservoir. The first fluid can comprise fluid in vapor form upon exiting the thermal test chamber, fluid that is in liquid form, or a mixture of vapor and liquid. In some examples, the first fluid can be at a temperature, for example, that is between 90°C and 120 °C, and the second fluid can be at a temperature, for example, that is between 10°C and 30 °C. The first and second fluid can be comprised of the same material. The first and second material can be comprised of, for example, water or a hydrofluoroether. The method of Figure 5 can be performed on a system that includes a plurality of semiconductor device systems. In some examples, the plurality of semiconductor device systems can be operated independently of each other so that a different temperature and/or pressure than that of a first semiconductor device systems is possible for a second semiconductor device systems.

Semiconductor devices can be, for example, any combination of microprocessors, CPUs (central processing units), GPUs (graphics processing units), processing cores, system on a chips, other processing hardware, a combination of processors or processing cores, programmable general-purpose or special-purpose microprocessors, accelerators, DSPs, I/O management, programmable controllers, ASICs, programmable logic devices (PLDs), HBM, and/or other memory devices. These semiconductor chip packages can be heterogeneous packages that incorporate different types of chips into one package. The semiconductor chips can be any of the chips, for example, described herein with respect to Figure 6. The semiconductor chip packages described herein generally can be part of various larger package structures and configurations and the foregoing examples are not meant to limit the types of assemblies that are possible.

Figure 6 depicts an example computing system which can be used in conjunction with, for example, the thermal management systems of Figures 2A - 2B and 3. For example, instructions for the methods of Figures 4 - 5, or for operating one or more aspects of the process described herein with respect to Figures 2A - 2B and 3 can be stored and/or run on the computing system. These instructions can be stored on a computer readable medium that is part of the computing system or is separate from the computing system. A computing system 600 can include more, different, or fewer features than the ones described with respect to Figure 6.

Computing system 600 includes processor 610, which provides processing, operation management, and execution of instructions for system 600. Processor 610 can include any type of microprocessor, CPU (central processing unit), GPU (graphics processing unit), processing core, or other processing hardware to provide processing for system 600, or a combination of processors or processing cores. Processor 610 controls the overall operation of system 600, and can be or include, one or more programmable general-purpose or special-purpose microprocessors, DSPs, programmable controllers, ASICs, programmable logic devices (PLDs), or the like, or a combination of such devices.

In one example, system 600 includes interface 612 coupled to processor 610, which can represent a higher speed interface or a high throughput interface for system components needing higher bandwidth connections, such as memory subsystem 620 or graphics interface components 640, and/or accelerators 642. Interface 612 represents an interface circuit, which can be a standalone component or integrated onto a processor die. Where present, graphics interface 640 interfaces to graphics components for providing a visual display to a user of system 600. In one example, the display can include a touchscreen display.

Accelerators 642 can be a fixed function or programmable offload engine that can be accessed or used by a processor 610. For example, an accelerator among accelerators 642 can provide data compression (DC) capability, cryptography services such as public key encryption (PKE), cipher, hash/authentication capabilities, decryption, or other capabilities or services. In some cases, accelerators 642 can be integrated into a CPU socket (e.g., a connector to a motherboard (or circuit board, printed circuit board, mainboard, system board, or logic board) that includes a CPU and provides an electrical interface with the CPU). For example, accelerators 642 can include a single or multi-core processor, graphics processing unit, logical execution unit single or multi-level cache, functional units usable to independently execute programs or threads, application specific integrated circuits (ASICs), neural network processors (NNPs), programmable control logic, and programmable processing elements such as field programmable gate arrays (FPGAs) or programmable logic devices (PLDs). Accelerators 642 can provide multiple neural networks, CPUs, processor cores, general purpose graphics processing units, or graphics processing units can be made available for use by artificial intelligence (AI) or machine learning (ML) models.

Memory subsystem 620 represents the main memory of system 600 and provides storage for code to be executed by processor 610, or data values to be used in executing a routine. Memory subsystem 620 can include one or more memory devices 630 such as read-only memory (ROM), flash memory, one or more varieties of random access memory (RAM) such as static RAM (SRAM), dynamic RAM (DRAM), synchronous DRAM (SDRAM) and/or or other memory devices, or a combination of such devices. Memory 630 stores and hosts, among other things, operating system (OS) 632 that provides a software platform for execution of instructions in system 600, and stores and hosts applications 634 and processes 636. In one example, memory subsystem 620 includes memory controller 622, which is a memory controller to generate and issue commands to memory 630. The memory controller 622 can be a physical part of processor 610 or a physical part of interface 612. For example, memory controller 622 can be an integrated memory controller, integrated onto a circuit within processor 610.

System 600 can also optionally include one or more buses or bus systems between devices, such memory buses, graphics buses, and/or interface buses. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a peripheral component interface (PCI) or PCI express (PCIe) bus, a Hyper Transport or industry standard architecture (ISA) bus, a small computer system interface (SCSI) bus, a universal serial bus (USB), or a Firewire bus.

In one example, system 600 includes interface 614, which can be coupled to interface 612. In one example, interface 614 represents an interface circuit, which can include standalone components and integrated circuitry. In one example, user interface components or peripheral components, or both, couple to interface 614. Network interface 650 provides system 600 the ability to communicate with remote devices (e.g., servers or other computing devices) over one or more networks. Network interface 650 can include an Ethernet adapter, wireless interconnection components, cellular network interconnection components, USB, or other wired or wireless standards-based or proprietary interfaces. Network interface 650 can transmit data to a device that is in the same data center or rack or a remote device, which can include sending data stored in memory.

Some examples of network interface 650 are part of an infrastructure processing unit (IPU) or data processing unit (DPU), or used by an IPU or DPU. An xPU can refer at least to an IPU, DPU, GPU, GPGPU (general purpose computing on graphics processing units), or other processing units (e.g., accelerator devices). An IPU or DPU can include a network interface with one or more programmable pipelines or fixed function processors to perform offload of operations that can have been performed by a CPU. The IPU or DPU can include one or more memory devices.

In one example, system 600 includes one or more input/output (I/O) interface(s) 660. I/O interface 660 can include one or more interface components through which a user interacts with system 600 (e.g., audio, alphanumeric, tactile/touch, or other interfacing). Peripheral interface 670 can include additional types of hardware interfaces, such as, for example, interfaces to semiconductor fabrication equipment and/or electrostatic charge management devices.

In one example, system 600 includes storage subsystem 680. Storage subsystem 680 includes storage device(s) 684, which can be or include any conventional medium for storing data in a nonvolatile manner, such as one or more magnetic, solid state, and/or optical based disks. Storage 684 can be generically considered to be a "memory," although memory 630 is typically the executing or operating memory to provide instructions to processor 610. Whereas storage 684 is nonvolatile, memory 630 can include volatile memory (e.g., the value or state of the data is indeterminate if power is interrupted to system 600). In one example, storage subsystem 680 includes controller 682 to interface with storage 684. In one example controller 682 is a physical part of interface 612 or processor 610 or can include circuits or logic in both processor 610 and interface 614.

A power source (not depicted) provides power to the components of system 600. More specifically, power source typically interfaces to one or multiple power supplies in system 600 to provide power to the components of system 600.

Examples of systems may be implemented in various types of computing, smart phones, tablets, personal computers, and networking equipment, such as switches, routers, racks, and blade servers such as those employed in a data center and/or server farm environment.

A system can comprise: a first computing system comprising one or more semiconductor devices, and a heat management system that is capable of absorbing heat emitted from the one or more semiconductor devices; a fluid inflow conduit that is capable of allowing fluid to flow into the heat management system and a fluid outflow conduit that is capable of allowing fluid to flow out of the heat management system; a cooling unit that is capable of cooling a fluid; a fluid condensation conduit that is capable of supplying cooled fluid to the fluid outflow conduit; and a fluid return conduit that is capable of accepting a mixture comprising fluid from the heat management system and cooled fluid. A diameter of the fluid return conduit can be between 0.25 inches and 0.75 inches. A diameter of the fluid return conduit can be between 0.375 inches and 0.5 inches. The system can additionally comprise a second computing system wherein a temperature of the second computing system is capable of being controlled independently of the first computing system. The system can additionally comprise a pressure sensor that is capable of measuring a pressure of fluid in the fluid return conduit. The first computing system can be a datacenter, a telecom system, a supercomputer, or a server. The system can additionally comprise a fluid reservoir.

A system can comprise: a first thermal test chamber comprise a temperature sensor that is capable of communicating a measured temperature to a temperature control system; a fluid inflow conduit that is capable of allowing fluid to flow into the first thermal test chamber and a fluid outflow conduit that is capable of allowing fluid to flow out of the first thermal test chamber; a cooling unit that is capable of cooling a fluid; a fluid condensation conduit that is capable of supplying fluid from the cooling unit to the outflow conduit; a fluid return conduit that is capable of accepting a mixture comprise fluid from the first thermal test chamber and fluid from the cooling unit; and a first valve between the first thermal test chamber and the fluid return conduit. A diameter of the fluid return conduit can be between 0.25 inches and 0.75 inches. A diameter of the fluid return conduit can be between 0.375 inches and 0.5 inches. The system can additionally comprise a second thermal test chamber wherein a temperature of the second thermal test chamber is capable of being controlled independently of a temperature of the first thermal test chamber. The system can additionally comprise a pressure sensor that is capable of measuring a pressure of fluid in the fluid return conduit. A second valve can be between the fluid condensation conduit and the fluid return conduit. The system can additionally comprise a heating unit that is capable of heating a fluid that has a saturation temperature, to a temperature that is at or above the saturation temperature.

A method can comprise: flowing a first fluid at a first temperature into a chamber wherein the chamber comprises a semiconductor device and wherein flowing the first fluid causes the chamber to reach a selected temperature; testing the semiconductor device at the selected temperature to determine a performance characteristic of the semiconductor device; emptying the first fluid from the chamber wherein emptying the first fluid comprises mixing the first fluid in an outflow conduit with a second fluid that is at a second temperature wherein the second temperature is lower than the first temperature; and flowing the first and second fluids through a fluid return conduit into a fluid reservoir. A diameter of the fluid return conduit can be between 0.25 inches and 0.75 inches. A diameter of the fluid return conduit can be between 0.375 inches and 0.5 inches. The method can also comprise measuring a pressure inside the fluid return conduit. The first fluid can be water or a hydrofluoroether. The method can also comprise measuring the pressure inside the chamber comprising a semiconductor device.

Besides what is described herein, various modifications can be made to what is disclosed and implementations without departing from their scope. Therefore, the drawings and examples herein should be construed in an illustrative, and not a restrictive sense.

## Claims

1. A system comprising:
a first computing system comprising one or more semiconductor devices, and a heat management system that is capable of absorbing heat emitted from the one or more semiconductor devices;
a fluid inflow conduit that is positioned to allow fluid to flow into the heat management system and a fluid outflow conduit that is positioned to allow fluid to flow out of the heat management system;
a cooling unit that is capable of cooling a fluid;
a fluid condensation conduit that is positioned to supply cooled fluid from the cooling unit to the fluid outflow conduit;
a valve that is positioned to allow mixing of the cooled fluid from the fluid condensation conduit and fluid from the fluid outflow conduit; and
a fluid return conduit that is capable of accepting a mixture comprising fluid from the fluid outflow conduit and cooled fluid from the cooling unit.

2. The system of claim 1 wherein a diameter of the fluid return conduit is between 0.375 inches and 0.5 inches.

3. The system of claim 1 additionally comprising a second computing system wherein a temperature of the second computing system is capable of being controlled independently of a temperature of the first computing system.

4. The system of claim 1 additionally comprising a pressure sensor that is capable of measuring a pressure of fluid in the fluid return conduit.

5. The system of claim 1 wherein the first computing system is a datacenter, a telecom system, a supercomputer, or a server.

6. A system comprising:
a first thermal test chamber comprising a temperature sensor that is capable of communicating a measured temperature to a temperature control system;
a fluid inflow conduit that is capable of allowing fluid to flow into the first thermal test chamber and a fluid outflow conduit that is capable of allowing fluid to flow out of the first thermal test chamber;
a cooling unit that is capable of creating a cooled fluid;
a fluid condensation conduit that is capable of supplying the cooled fluid from the cooling unit to the fluid outflow conduit;
a fluid return conduit that is capable of accepting a mixture comprising fluid from the first thermal test chamber and fluid from the cooling unit; and
a first valve between the first thermal test chamber and the fluid return conduit.

7. The system of claim 6 wherein a diameter of the fluid return conduit is between 0.25 inches and 0.75 inches.

8. The system of claim 6 additionally comprising a second thermal test chamber wherein a first temperature of the second thermal test chamber is capable of being controlled independently of a second temperature of the first thermal test chamber.

9. The system of claim 6 additionally comprising a pressure sensor that is capable of measuring a pressure of fluid in the fluid return conduit.

10. The system of claim 6 additionally comprising a heating unit that is capable of heating a fluid that has a saturation temperature, to a temperature that is at or above the saturation temperature.

11. A method comprising:
flowing a first fluid at a first temperature into a chamber wherein the chamber comprises a semiconductor device and wherein flowing the first fluid causes the chamber to reach a selected temperature;
testing the semiconductor device at the selected temperature to determine a performance characteristic of the semiconductor device;
emptying the first fluid from the chamber wherein emptying the first fluid comprises mixing the first fluid in an outflow conduit with a second fluid that is at a second temperature wherein the second temperature is lower than the first temperature; and
flowing the first and second fluids through a fluid return conduit into a fluid reservoir.

12. The method of claim 11 wherein a diameter of the fluid return conduit is between 0.375 inches and 0.5 inches.

13. The method of claim 11 also comprising measuring a pressure inside the fluid return conduit.

14. The method of claim 11 wherein the first fluid is water or a hydrofluoroether.

15. The method of claim 11 also comprising measuring a pressure inside the chamber comprising a semiconductor device.
